# EUROPEAN PATENT APPLICATION

(11) **EP 3 480 859 A1**
(43) Date of publication of application: **08.05.2019**
(21) Application number: 17819184.7
(22) Date of filing: 23.06.2017
(51) Int. Cl.: H01L 31/05, H01L 31/0224

(54) **BATTERY CELL, BATTERY CELL MATRIX, SOLAR CELL, AND BATTERY CELL PREPARATION METHOD**

(30) Priority: 30.06.2016 CN 201610516487
(71) Applicant: BYD Company Limited, Shenzhen, Guangdong 518118 (CN)
(72) Inventor: SUN, Xiang, Shenzhen, Guangdong 518118 (CN); YAO, Yunjiang, Shenzhen, Guangdong 518118 (CN); TIAN, Ye, Shenzhen, Guangdong 518118 (CN); ZHOU, Yuntan, Shenzhen, Guangdong 518118 (CN); TENG, Meiling, Shenzhen, Guangdong 518118 (CN); JIANG, Zhanfeng, Shenzhen, Guangdong 518118 (CN)
(74) Representative: Hoffmann Eitle
(86) International application number: PCT/CN2017/089819
(87) International publication number: WO 2018/001187

(57) **Abstract**

The disclosure discloses a photovoltaic cell, a photovoltaic cell array, a solar cell, and a method for preparing a photovoltaic cell. The photovoltaic cell includes: a silicon wafer, a gate line layer, a side electrode, a first electrode, a back electrical layer, and a second electrode. The silicon wafer includes a silicon substrate, a front diffusion layer, a side division layer, and a back division layer. At least a part of at least one of the side division layer and the back division layer is a diffusion layer whose type is the same as that of the front diffusion layer. The gate line layer is disposed on the front diffusion layer. The side electrode is disposed on the side division layer and is electrically connected to the gate line layer. The first electrode is disposed on the back division layer and is electrically connected to the side electrode. The back electrical layer and the second electrode are both disposed on a back surface of the silicon wafer. The back electrical layer is electrically connected to the second electrode and is not in contact with the first electrode.

## Description

### FIELD

The disclosure relates to the field of solar cell technologies, and in particular, to a photovoltaic cell, a photovoltaic cell array, a solar cell, and a method for preparing a photovoltaic cell.

### BACKGROUND

For a crystalline silicon solar photovoltaic cell in the related art, each of a back surface and a front surface has 2 to 3 silver primary gate lines as positive and negative electrodes of the photovoltaic cell. These silver primary gate lines not only consume a large amount of silver paste, but also cause a decrease in the efficiency of the photovoltaic cell because of blocking incident light. In addition, the positive and negative electrodes are respectively distributed on the back surface and the front surface of the photovoltaic cell. Therefore, when photovoltaic cells are connected in series, a negative electrode of a front surface of a photovoltaic cell needs to be welded to a positive electrode of a back surface of a neighboring photovoltaic cell by using a solder strip. As a result, problems such as a cumbersome welding process and a large use amount of a welding material are caused. Moreover, during welding and in a subsequent lamination process, the photovoltaic cells and the solder strip are easily damaged. Wherein the font surface refers to the light-receiving surface, the back surface refers to the backlight surface.

In addition, the photovoltaic cell array in the related art is usually formed by connecting 72 or 60 photovoltaic cells in series sequentially, to form three loops formed by six cell strings. In this case, at least three diodes are usually required, so that one diode is disposed on each loop to perform bypass protection. A diode is usually disposed in a connection box of a cell. As a result, the costs of the integrated connection box are increased, and the structural complexity of the cell is increased. Moreover, when series-connected components formed by connecting a plurality of photovoltaic cells in series are connected in series again, the use amount of a connection cable is large, and the material waste is huge. As a result, the costs of a power station are increased.

### SUMMARY

The disclosure aims to resolve at least one of the technical problems existing in the prior art. For this purpose, the disclosure provides a photovoltaic cell, and the photovoltaic cell has good anti-leakage performance and high power.

The disclosure further provides a method for preparing the foregoing photovoltaic cell.

The disclosure further provides a photovoltaic cell array having the foregoing photovoltaic cell.

The disclosure further provides a solar cell having the foregoing photovoltaic cell array.

The photovoltaic cell according to a first aspect of the disclosure includes: a silicon wafer, where the silicon wafer includes a silicon substrate, a front diffusion layer, a side division layer, and a back division layer, where a back surface of the silicon substrate includes a first area and a second area, the front diffusion layer is disposed on a front surface of the silicon substrate, the side division layer is disposed on a side surface of the silicon substrate, and the back division layer is disposed on only and fully covers the first area, where at least a part of at least one of the side division layer and the back division layer is a diffusion layer whose type is the same as that of the front diffusion layer; a gate line layer, where the gate line layer is disposed on the front diffusion layer; a side electrode, where the side electrode is disposed on the side division layer and is electrically connected to the gate line layer; a first electrode, where the first electrode is disposed on the back division layer and is electrically connected to the side electrode; and a back electrical layer and a second electrode, where the back electrical layer and the second electrode are both disposed on the second area, where the back electrical layer is electrically connected to the second electrode and is not in contact with the first electrode. Wherein a back surface of the silicon substrate refers to the backlight surface of the silicon substrate, a front surface of the silicon substrate refers to the light-receiving surface of the silicon substrate.

The photovoltaic cell according to the disclosure has good anti-leakage performance and high power.

In some embodiments, the back division layer is a back diffusion layer fully covering the first area.

In some embodiments, the silicon substrate is of a P-type, and each of the front diffusion layer and the back diffusion layer is a phosphorus diffusion layer.

In some embodiments, when being projected along a thickness direction of the silicon wafer, each outer edge of the first electrode falls on a profile line of the first area.

In some embodiments, each of the first area and the second area is a non-discrete area.

In some embodiments, a gap exists between the first area and the second area.

In some embodiments, the back electrical layer fully covers the second area, and the second electrode is disposed on the back electrical layer.

In some embodiments, the side division layer is a side diffusion layer fully covering the side surface of the silicon substrate.

In some embodiments, the silicon substrate is of a P-type, and each of the front diffusion layer and the side diffusion layer is a phosphorus diffusion layer.

In some embodiments, the gate line layer includes a plurality of secondary gate lines extending perpendicular to a length direction of the side electrode.

In some embodiments, a span of the silicon wafer in a direction perpendicular to the side electrode is 20 mm to 60 mm.

In some embodiments, the silicon wafer is a rectangular sheet, the first electrode and the second electrode are respectively disposed against two long sides of the silicon wafer and extend along a length direction of the silicon wafer, and the side electrode is disposed on a side surface, of the silicon wafer, adjacent to a long side on a side of the first electrode.

In some embodiments, the photovoltaic cell further includes: an anti-reflection layer, where the anti-reflection layer is disposed between the gate line layer and the front diffusion layer.

In some embodiments, the anti-reflection layer is further disposed between the side electrode and the side division layer.

The method for preparing a photovoltaic cell according to a second aspect of the disclosure is used to prepare the photovoltaic cell according to the first aspect of the disclosure, and the preparation method includes the following steps: A: obtaining the silicon substrate; B: preparing the front diffusion layer, the side division layer, and the back division layer on the silicon substrate to obtain the silicon wafer; and C: preparing the back electrical layer, the second electrode, the first electrode, the side electrode, and the gate line layer on the silicon wafer.

In some embodiments, step A is specifically: dividing a square regular silicon substrate body at least once according to an unchanged length rule, so as to obtain a plurality of silicon substrates.

In some embodiments, the back division layer is a back diffusion layer fully covering the first area, the side division layer is a side diffusion layer fully covering the side surface of the silicon substrate, and step B is specifically: B1: preparing a same type of diffusion layers on all surfaces of the silicon substrate; B2: applying a protection layer onto parts of the diffusion layer that are used as the front diffusion layer, the side diffusion layer, and the back diffusion layer; B3: removing a part, of the diffusion layer, onto which the protection layer is not applied; and B4: removing the protection layer, so as to obtain the front diffusion layer, the side diffusion layer, and the back diffusion layer.

The photovoltaic cell array according to a third aspect of the disclosure is formed by connecting photovoltaic cells according to the first aspect of the disclosure in series and/or in parallel.

The solar cell according to a fourth aspect of the disclosure includes the photovoltaic cell array according to the third aspect of the disclosure.

Additional aspects and advantages of embodiments of the disclosure will be given in part in the following descriptions, become apparent in part from the following descriptions, or be learned from the practice of the embodiments of the disclosure.

### BRIEF DESCRIPTION OF THE DRAWINGS

FIG. 1 is a schematic diagram of a front side of a photovoltaic cell according to an embodiment of the disclosure;
FIG. 2 is a schematic diagram of a back side of the photovoltaic cell shown in FIG. 1;
FIG. 3 is a schematic diagram of a side surface of the photovoltaic cell shown in FIG. 2;

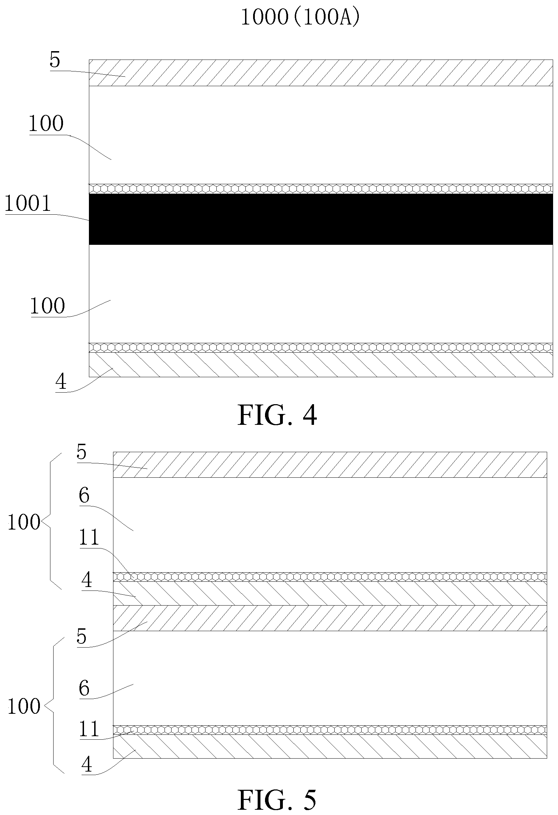

FIG. 4 is a schematic diagram of connecting two photovoltaic cells shown in FIG. 1 in series by using a conductive band;
FIG. 5 is a schematic diagram of the two photovoltaic cells shown in FIG. 4 having the conductive band removed;

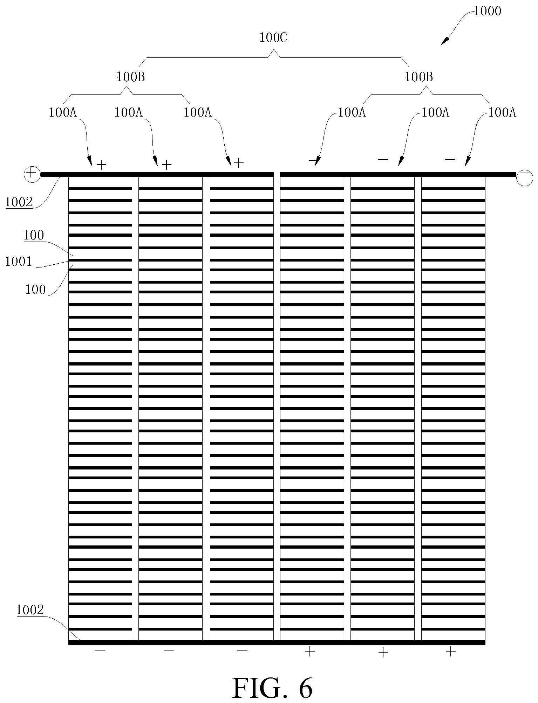

FIG. 6 is a schematic diagram of a photovoltaic cell array according to an embodiment of the disclosure; and

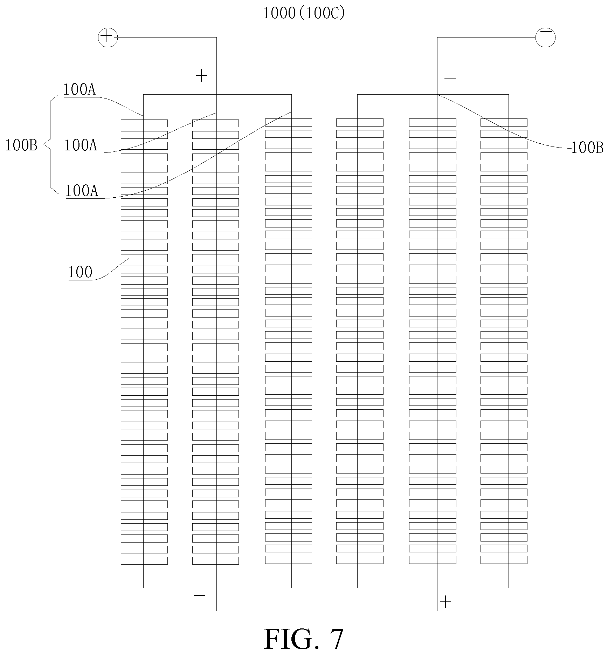

FIG. 7 is a schematic diagram of a circuit of the photovoltaic cell array shown in FIG. 6.

### Reference numerals of the accompanying drawings:

photovoltaic cell array 1000; solder strip 1001; busbar 1002;
first photovoltaic cell array 100A; second photovoltaic cell array 100B; third photovoltaic cell array 100C;
photovoltaic cell 100;
silicon wafer 1; silicon substrate 11; front diffusion layer 12; side diffusion layer 13; back diffusion layer 14; anti-reflection layer 101;
gate line layer 2; secondary gate line 21; side electrode 3; first electrode 4; second electrode 5;
back electrical layer 6.

### DETAILED DESCRIPTION

Reference will be made in detail to embodiments of the disclosure. The embodiments described herein with reference to drawings are explanatory, illustrative, and should be used to generally understand the present invention. The embodiments described below with reference to the accompanying drawings are exemplary, aiming to explain the disclosure, but cannot be understood as a limitation on the disclosure.

The following provides lots of different embodiments or examples to achieve different structures of the disclosure. To simplify the disclosure, components and settings of specific examples are described below. Certainly, they are merely examples, and are not intended to limit the disclosure. In addition, the disclosure can repeat reference numbers and/or reference letters in different examples, but such repetitions are for simplification and clarity, which do not indicate relationships between the embodiments and/or settings discussed. In addition, the disclosure provides examples of various specific processes and materials, but those of ordinary skill in the art can realize applicability of other processes and/or use of other materials.

A photovoltaic cell 100 according to an embodiment of a first aspect of the disclosure is described below with reference to the accompanying drawings. The photovoltaic cell 100 is a back contact-type solar photovoltaic cell for converting solar energy into electric energy.

The photovoltaic cell 100 according to this embodiment of the disclosure includes: a silicon wafer 1, a gate line layer 2, a side electrode 3, a first electrode 4, a back electrical layer 6, and a second electrode 5. The silicon wafer 1 includes a silicon substrate 11, a front diffusion layer 12, a side division layer, and a back division layer.

The silicon substrate 11 is sheet-shaped, and two surfaces of the silicon substrate 11 in a thickness direction are respectively a front surface and a back surface, and the front surface is connected to the back surface by using a side surface. The front diffusion layer 12 is disposed on the front surface of the silicon substrate 11. For example, in an optional embodiment of the disclosure, the front diffusion layer 12 fully covers the front surface of the silicon substrate 11, thereby reducing the manufacturing difficulty of the front diffusion layer 12, increasing the manufacturing efficiency, and reducing the manufacturing costs.

The side division layer is disposed on a side surface of the silicon substrate 11. For example, the side division layer may be disposed on only one side surface of the silicon substrate 11, or may be disposed on a plurality of side surfaces. Optionally, the side division layer is disposed on only one side surface of the silicon substrate 11 and fully covers the side surface. Therefore, it is convenient to manufacture and fabricate the side division layer.

The side electrode 3 is disposed on the side division layer. That is, the side electrode 3 may be directly or indirectly disposed on the side division layer. In this case, the side electrode 3 is disposed on a side surface of the silicon wafer 1 and corresponds to the side division layer. That is, when being projected along a direction perpendicular to the side surface on which the side division layer is located, the side electrode 3 does not exceed the profile line of the side division layer.

The side electrode 3 is disposed on the side surface of the silicon wafer 1, and is not embedded in the silicon wafer 1. Therefore, the entire manufacturing difficulty of the photovoltaic cell 100 can be reduced, the manufacturing process can be simplified, the manufacturing efficiency can be increased, and the manufacturing costs can be reduced.

The back surface of the silicon substrate 11 includes a first area and a second area, and the first area and the second area have no intersection set. The first area and the second area may be in contact with each other or be not in contact with each other. That is, the profile line of the first area and the profile line of the second area may be in contact with each other or be not in contact with each other. For example, when a part of the back division layer in contact with or close to the back electrical layer 6 is an insulation layer, the first area and the second area may be in contact with each other, and when a part of the back division layer in contact with or close to the back electrical layer 6 is a diffusion layer whose type is the same as that of the front diffusion layer 12, the first area and the second area may be not in contact with each other.

The first area may be a non-discrete area. That is, when the first area is randomly divided into a plurality of sub-areas, the plurality of sub-areas may be all in communication with each other to form a continuous first area. The second area may be a non-discrete area. That is, when the second area is randomly divided into a plurality of sub-areas, the plurality of sub-areas may be all in communication with each other to form a continuous second area.

The back division layer is disposed on only the first area. That is, a remaining surface on the back surface of the silicon substrate 11 other than the first area does not have the back division layer, and further, the back division layer fully covers the first area. In this way, when the first area is a non-discrete continuous area, the back division layer may be non-discretely, that is, continuously arranged on the silicon substrate 11.

Therefore, the back division layer is arranged on the silicon substrate 11 continuously, that is, non-discretely, and is not scattered on the silicon substrate 11 discretely, that is, discontinuously, for example, in a discrete form such as a scattered-point shape or a zebra shape. Therefore, the manufacturing difficulty of the back division layer is greatly reduced, the manufacturing efficiency is increased, the manufacturing costs are reduced, and the power of the photovoltaic cell 100 can be effectively increased.

The gate line layer 2 is disposed on the front diffusion layer 12. That is, the gate line layer 2 may be directly or indirectly disposed on the front diffusion layer 12. In this case, the gate line layer 2 is disposed on the front surface of the silicon wafer 1 and corresponds to the front diffusion layer 12. In other words, when being projected along the thickness direction of the silicon wafer 1, the gate line layer 2 does not exceed the profile line of the front diffusion layer 12. Wherein a front surface of the silicon wafer refers to the light-receiving surface of the silicon wafer, a back surface of the silicon wafer refers to the backlight surface of the silicon wafer.

For example, in some embodiments of the disclosure, the silicon wafer 1 may further include an anti-reflection layer 101, and the anti-reflection layer 101 may be disposed on the front diffusion layer 12. In this way, when the silicon wafer 1 includes the anti-reflection layer 101, the gate line layer 2 may be directly disposed on the anti-reflection layer 101. However, when the silicon wafer 1 does not include the anti-reflection layer 101, the gate line layer 2 may be directly disposed on the front diffusion layer 12.

The first electrode 4 is disposed on the back division layer. That is, the first electrode 4 may be directly or indirectly disposed on the back division layer. In this case, the first electrode 4 is disposed on the back surface of the silicon wafer 1 and corresponds to the first area. In other words, when being projected along the thickness direction of the silicon wafer 1, the first electrode 4 does not exceed the first area. For example, the first electrode 4 may be further indirectly disposed on the back division layer by using a passivation layer.

The back electrical layer 6 and the second electrode 5 are both disposed on the second area. That is, the back electrical layer 6 and the second electrode 5 may be directly or indirectly disposed on the second area on the back surface of the silicon substrate 11. In this case, the back electrical layer 6 and the second electrode 5 are disposed on the back surface of the silicon wafer 1 and correspond to the second area. That is, when being projected along the thickness direction of the silicon wafer 1, the back electrical layer 6 and the second electrode 5 do not exceed the second area. For example, the back electrical layer 6 and the second electrode 5 may be further indirectly disposed on the back surface of the silicon substrate 11 by using a passivation layer. The first electrode 4 is neither in contact with the back electrical layer 6, nor in contact with the second electrode 5.

In addition, it should be noted that, in some embodiments of the disclosure, the back electrical layer 6 and the second electrode 5 may be not superimposed on each other and are in contact connection with each other. In this case, the back electrical layer 6 and the second electrode 5 are respectively completely disposed on the back surface of the silicon wafer 1, are in direct contact with each other and are electrically connected to each other. Therefore, the space can be fully used, and the power of the photovoltaic cell 100 is increased. In some other embodiments of the disclosure, the back electrical layer 6 and the second electrode 5 may be further superimposed on each other. In this case, a union set surface obtained after the back electrical layer 6 and the second electrode 5 are superimposed is disposed on the back surface of the silicon wafer 1.

Herein, it should be noted that, when a conductive medium is disposed (for example, directly disposed or indirectly disposed by using the anti-reflection layer 101 described herein) on the front diffusion layer 12, a type of charges may be collected; and when a conductive medium is disposed (for example, directly disposed or indirectly disposed by using the anti-reflection layer 101 or the passivation layer described herein) on a surface that is on the silicon substrate 11 and that does not have the front diffusion layer 12, another type of charges may be collected. Herein, it should be noted that, the principle in which a conductive medium collects charges from the silicon wafer should be well known by a person skilled in the art. Details are not described herein again.

For example, when the silicon substrate 11 is P-type silicon, the front diffusion layer 12 may be a phosphorus diffusion layer. In this case, a conductive medium disposed on the phosphorus diffusion layer may collect negative charges, and a conductive medium disposed on a non-phosphorus diffusion layer may collect positive charges.

In this way, because the gate line layer 2 is disposed (for example, directly disposed or indirectly disposed by using the anti-reflection layer 101) on the front diffusion layer 12, the gate line layer 2 may collect a first type of charges (for example, negative charges). The back electrical layer 6 is disposed (for example, directly disposed or indirectly disposed by using a passivation layer) on the back surface of the silicon substrate 11, so that the back electrical layer 6 may collect a second type of charges (for example, positive charges).

In addition, the anti-reflection layer 101 may be further disposed between the side electrode 3 and the side division layer described herein. In this case, an external surface of each of the entire front surface and one side surface of the silicon wafer 1 may have the anti-reflection layer 101, thereby facilitating manufacturing and fabrication. In addition, it should be noted that, the concept of the anti-reflection layer 101 described herein should be well known by a person skilled in the art, and the anti-reflection layer mainly plays a role of reducing reflection and strengthening charge collection. For example, materials of the anti-reflection layer 101 may include but are not limited to TiO2, Al2O3, SiNxOy, and SiNxCy.

Specifically, the first electrode 4 is electrically connected to the gate line layer 2 by using the side electrode 3, so that the first type of charges (for example, negative charges) collected by the gate line layer 2 may be transferred to the first electrode 4 (for example, the negative electrode); and the second electrode 5 is electrically connected to the back electrical layer 6, so that the second type of charges (for example, positive charges) collected by the back electrical layer 6 may be transferred to the second electrode 5 (for example, the positive electrode). Therefore, the first electrode 4 and the second electrode 5 may serve as the positive and negative electrodes of the photovoltaic cell 100 to output the electric energy. In addition, because the side electrode 3 is disposed on a side surface of the silicon wafer 1, the gate line layer 2 can be effectively electrically connected to the first electrode 4 simply and conveniently by using the side electrode 3, thereby ensuring the operating reliability of the photovoltaic cell 100.

A person skilled in the art may understand that, the first electrode 4 and the second electrode 5 are electrodes whose polarities are opposite, that is, are not conductively connected to each other or not electrically connected to each other. In this case, the first electrode 4, all components electrically connected to the first electrode 4 and the second electrode 5, and all components electrically connected to the second electrode 5 cannot be directly conductively connected, and cannot be indirectly conductively connected by using any external conductive medium either, for example, may be not in contact with each other or be isolated by using an insulation material, thereby preventing the first electrode 4 and the second electrode 5 from being short-circuited.

The back division layer is constructed to prevent the first electrode 4 and the second electrode 5 from being short-circuited by using the silicon substrate 11, that is, to prevent the first electrode 4 and the silicon substrate 11 from being in direct contact with each other to cause short-circuit. For example, the back division layer may be a diffusion layer whose type is the same as that of the front diffusion layer 12, and/or an insulation layer. That is, the back division layer may be completely a diffusion layer whose type is the same as that of the front diffusion layer 12, or may be completely an insulation layer, or a part of the back division layer may be a diffusion layer whose type is the same as that of the front diffusion layer 12, and a remaining part is an insulation layer.

When the first electrode 4 is disposed on the silicon substrate 11 by using the insulation layer, the first electrode 4 may be directly insulated from the silicon substrate 11, to prevent the first electrode 4 from collecting, from the silicon substrate 11, charges whose type is the same as that of charges collected by the second electrode 5, thereby effectively preventing the first electrode 4 from being conductively connected to the second electrode 5 by using the silicon substrate 11 to cause short-circuit, that is, preventing the first electrode 4 and the silicon substrate 11 from being in direct contact with each other to cause short-circuit.

When the first electrode 4 is disposed on the silicon substrate 11 by using a diffusion layer whose type is the same as that of the front diffusion layer 12, the first electrode 4 may collect, from the diffused silicon substrate 11, charges whose type is the same as that of charges collected by the gate line layer 2, that is, charges whose type is opposite to that of charges collected by the second electrode 5, thereby also preventing the first electrode 4 and the second electrode 5 from being short-circuited, and increasing the power of the photovoltaic cell 100.

The side division layer is constructed to prevent the side electrode 3 and the second electrode 5 from being short-circuited by using the silicon substrate 11, thereby preventing the first electrode 4 and the second electrode 5 from being short-circuited, that is, preventing the side electrode 3 and the silicon substrate 11 from being in direct contact with each other to cause short-circuit. For example, the side division layer may be a diffusion layer whose type is the same as that of the front diffusion layer 12, and/or an insulation layer. That is, the side division layer may be completely a diffusion layer whose type is the same as that of the front diffusion layer 12, or may be completely an insulation layer, or a part of the side division layer may be a diffusion layer whose type is the same as that of the front diffusion layer 12, and a remaining part is an insulation layer.

When the side electrode 3 is disposed on the silicon substrate 11 by using the insulation layer, the side electrode 3 may be directly insulated from the silicon substrate 11, to prevent the side electrode 3 from collecting, from the silicon substrate 11, charges whose type is the same as that of charges collected by the second electrode 5, thereby effectively preventing the side electrode 3 from being conductively connected to the second electrode 5 by using the silicon substrate 11 to cause short-circuit, that is, preventing the side electrode 3 and the silicon substrate 11 from being in direct contact with each other to cause short-circuit.

When the side electrode 3 is disposed on the silicon substrate 11 by using a diffusion layer whose type is the same as that of the front diffusion layer 12, the side electrode 3 may collect, from the diffused silicon substrate 11, charges whose type is the same as that of charges collected by the gate line layer 2, that is, charges whose type is opposite to that of charges collected by the second electrode 5, thereby also preventing the side electrode 3 and the second electrode 5 from being short-circuited, that is, preventing the side electrode 3 and the silicon substrate 11 from being in direct contact with each other to cause short-circuit, and increasing the power of the photovoltaic cell 100.

Specifically, in an embodiment of the disclosure, at least a part of at least one of the side division layer and the back division layer is a diffusion layer whose type is the same as that of the front diffusion layer 12. That is, either at least a part of the side division layer is a diffusion layer whose type is the same as that of the front diffusion layer 12, or at least a part of the back division layer is a diffusion layer whose type is the same as that of the front diffusion layer 12, thereby not only ensuring the effect of insulation between the first electrode 4 and the second electrode 5, but also increasing the power of the photovoltaic cell 100.

Optionally, the back division layer is completely a diffusion layer whose type is the same as that of the front diffusion layer 12. That is, the back division layer is a back diffusion layer 14 fully covering the first area. Therefore, manufacturing is facilitated and insulation reliability is good. Optionally, the side division layer is completely a diffusion layer whose type is the same as that of the front diffusion layer 12. That is, the side division layer is a side diffusion layer 13 fully covering the side surface of the silicon substrate 11. Therefore, manufacturing is facilitated and insulation reliability is good.

Herein, it should be noted that, concepts such as the silicon substrate, the diffusion layer, the anti-reflection layer, and the passivation layer, and the principle in which a conductive medium collects charges from the silicon wafer are all well known by a person skilled in the art. Details are not described herein again.

In addition, in an optional embodiment of the disclosure, the gate line layer 2 may be a conductive dielectric layer formed by a plurality of conductive fine gate lines disposed at intervals, where the fine gate line may be made of a silver material. Therefore, on one hand, the conductive rate can be increased, and on the other hand, the light shielding area can be reduced, thereby increasing the power of the photovoltaic cell 100 in disguised form. The back electrical layer 6 may be an aluminum layer, that is, an aluminum back-surface field. Therefore, on one hand, the conductive rate can be increased, and on the other hand, the costs can be reduced.

To sum up, in the photovoltaic cell 100 according to this embodiment of the disclosure, because at least a part of at least one of the back division layer and the side division layer is a diffusion layer whose type is the same as that of the front diffusion layer 12, not only insulation between the first electrode 4 and the second electrode 5 can be ensured, but also the power of the photovoltaic cell 100 can be effectively increased.

Moreover, by disposing the side electrode 3 on the side surface of the silicon substrate 11, the first electrode on the front surface of the existing photovoltaic cell may be migrated from the front side of the silicon wafer to the back side, so as to prevent the first electrode from performing light shielding on the front side of the silicon wafer. Therefore, compared with the existing photovoltaic cell, the power of the photovoltaic cell 100 of the disclosure is higher. Moreover, the first electrode 4 and the second electrode 5 of the photovoltaic cell 100 of the disclosure are located on a same side of the silicon wafer 1, thereby facilitating electrical connection between a plurality of photovoltaic cells 100, reducing the welding difficulty, reducing the solder use amount, and also reducing the damage probability of the photovoltaic cell 100 during welding and in the subsequent lamination process. Wherein the back surface of the photovoltaic cell refers to the backlight surface of the of the photovoltaic cell, the front surface of the of the photovoltaic cell refers to the light-receiving surface of the of the photovoltaic cell. The font surface refers to the light-receiving backlight surface, the back surface refers to the backlight surface. The font side refers to the light-receiving side, the back side refers to the backlight side.

In addition, the side electrode 3 is disposed on the side surface of the silicon wafer 1, thereby greatly reducing the manufacturing difficulty of the photovoltaic cell 100 (for example, manufacturing processes such as manufacturing a hole on the silicon wafer 1 and injecting a conductive medium into the hole are not required), and then improving the manufacturing rate and reducing the manufacturing failure rate and the manufacturing costs. In addition, when the side electrode 3 is disposed on a side surface on a side in the width direction of the silicon substrate 11, the path of transferring charges from the front side of the silicon wafer 1 to the back side can be effectively shortened, to improve the charge transfer rate, thereby increasing the power of the photovoltaic cell 100 in disguised form.

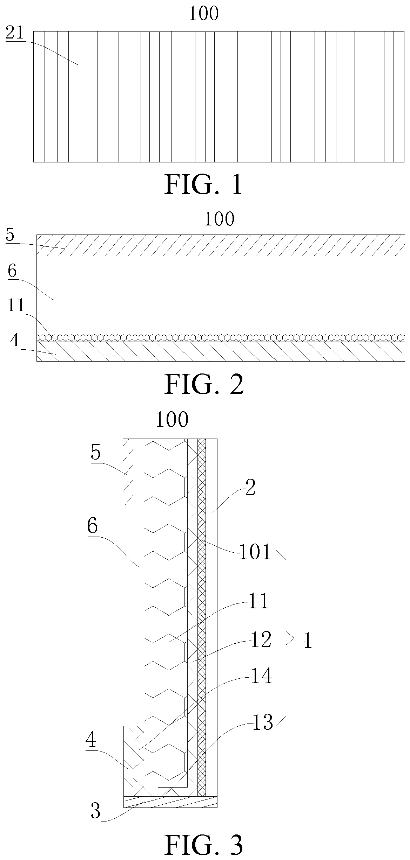

In an embodiment of the disclosure, a span of the silicon wafer 1 in a direction perpendicular to the side electrode 3 is 20 mm to 60 mm. That is, the silicon wafer 1 includes a group of (two) side surfaces disposed opposite to each other, where the side electrode 3 is disposed on one side surface, and the distance between this group of side surfaces is 20 mm to 60 mm. For example, in the example shown in FIG. 2 and FIG. 3, when the silicon wafer 1 is a rectangular sheet, and the side electrode 3 is disposed on a side surface on a long side of the silicon wafer 1, the width of the silicon wafer 1 is 20 mm to 60 mm. For example, in another example of the disclosure (the example is not shown), when the silicon wafer 1 is a rectangular sheet, and the side electrode 3 is disposed on a side surface on a broad side of the silicon wafer 1, the length of the silicon wafer 1 is 20 mm to 60 mm. Therefore, a path of charges transmitted from the front surface of the silicon wafer 1 to the back surface can be shortened, thereby increasing the charge transfer rate, and then increasing the power of the photovoltaic cell 1 00.

For example, in an optional example of the disclosure, the silicon substrate 11 is a rectangular sheet, which is a rectangular sheet or a square sheet. Herein, it should be noted that, the "rectangular sheet" is understood broadly, that is, is not limited to a strictly rectangular sheet. For example, a roughly rectangular sheet such as a rectangular sheet whose four vertex angles have rounded corners or chamfers also falls within the protection scope of the disclosure. Therefore, it is convenient to manufacture the photovoltaic cells 100, and it is convenient to connect the photovoltaic cells 100.

Optionally, the silicon substrate 11 is a rectangular sheet. For example, the silicon substrate 11 may be formed by dividing (which means only "separating" and does not particularly mean "taking a cutting process") a square silicon wafer body in an unchanged length manner. That is, a square silicon wafer body may be divided into a plurality of rectangular sheet-shaped silicon substrates 11 in an unchanged length manner. In this case, the length of each silicon substrate 11 is equal to the length of the square silicon wafer body, and a sum of widths of the plurality of silicon substrates 11 is equal to the width of the square silicon wafer body.

Optionally, when the first area and the second area are each a non-discrete area, have no intersection set, and are not in contact with each other, the first electrode 4 whose area is relatively large may be manufactured. Optionally, when being projected along a thickness direction of the silicon wafer 1, outer edges of the first electrode 4 fall on a profile line of the first area. Therefore, the first area can be maximally used, to increase the power of the photovoltaic cell 100. Herein, it should be noted that, for a planar component (for example, the rectangular sheet-shaped first electrode 4 and second electrode 5 described herein), the "outer edge" is the profile line of the planar component, and for a linear component (for example, the fine gate line described herein), the "outer edge" is two endpoints of the linear component.

Optionally, when the first area and the second area are each a non-discrete area, have no intersection set, and are not in contact with each other, the back electrical layer 6 whose area is relatively large may be manufactured. Optionally, the back electrical layer 6 fully covers the second area, and the second electrode 5 is disposed on the back electrical layer 6. Therefore, the second area can be maximally used, to increase the power of the photovoltaic cell 100.

In an optional embodiment of the disclosure, the gate line layer 2 includes a plurality of secondary gate lines 21 extending perpendicular to a length direction of the side electrode 3. That is, each secondary gate line 21 is perpendicular to the length direction of the side electrode 3. Therefore, the charge transmission path of the secondary gate line 21 can be shortened, thereby improving the charge transmission efficiency, and increasing the power of the photovoltaic cell 100.

A photovoltaic cell 100 of a specific embodiment of the disclosure is described below by using only an example in which a silicon wafer 1 is a rectangular sheet.

Optionally, each of the first area and the second area may be rectangular, each of the length of the first area and the length of the second area is equal to the length of the silicon substrate 11, a sum of the width of the first area and the width of the second area is less than the width of the silicon substrate 11, and the first area and the second area are spaced in the width direction of the silicon substrate 11. Optionally, the first area and the second area are respectively disposed against two long sides of the silicon substrate 11. That is, the silicon substrate 11 may be divided, by using two straight lines in parallel to the long sides of the silicon substrate 11, into the first area and the second area located on two sides of the two straight lines, and an area between the two straight lines is a gap area between the first area and the second area. Therefore, the subsequent manufacturing is facilitated. Certainly, the disclosure is not limited thereto. The shape of the first area and the shape of the second area are not limited. For example, the first area and the second area may be further formed into a triangle, a semi-circle, or the like.

Optionally, the first electrode 4 and the second electrode 5 are respectively disposed against two long sides of the silicon wafer 1 and extend along a length direction of the silicon wafer 1, and the side electrode 3 is disposed on a side surface, of the silicon wafer 1, adjacent to a long side on a side of the first electrode 4 (as shown in FIG. 2 and FIG. 3). That is, the side electrode 3 is disposed on a side surface, of the silicon wafer 1 in the width direction, adjacent to a side of the first electrode 4. That is, the first electrode 4 and the second electrode 5 are spaced in the width direction of the silicon wafer 1, and are respectively disposed against the two long sides of the silicon wafer 1, and the side electrode 3 is disposed on a side surface on a long side of the silicon wafer 1, that is, is disposed on a side surface on a side of the silicon wafer 1 in the width direction on, and is located on a side close to the first electrode 4. Therefore, the charge transmission path is shorter, the power of the photovoltaic cell 100 is higher, the photovoltaic cell 100 is manufactured more simply and conveniently, and it is more convenient to connect the photovoltaic cells 100.

Optionally, each of the first electrode 4 and the second electrode 5 may be a rectangular sheet and has a length equal to the length of the silicon substrate 11, so that two broad sides and one long side of each of the first electrode 4 and the second electrode 5 may be respectively aligned with two broad sides and one long side of the silicon substrate 11. Then, the space can be fully used, the power of the photovoltaic cell 100 is increased, and it is convenient to subsequently connect the photovoltaic cells 100.

In addition, the side electrode 3 may also be constructed to be sheet-shaped and fully occupy a side surface on a side in the width direction of the silicon wafer 1, thereby increasing the power of the photovoltaic cell 100. Certainly, specific structures of the side electrode 3, the first electrode 4, and the second electrode 5 are not limited thereto. For example, the side electrode 3, the first electrode 4, and the second electrode 5 may be further respectively formed into discrete electrodes by a plurality of sub-electrodes distributed at intervals.

A method for preparing a photovoltaic cell 100 according to an embodiment of a second aspect of the disclosure is described below with reference to the accompanying drawings.

Specifically, the preparation method includes the following step A, step B, and step C.

Step A: Obtain a silicon substrate 11. For example, a plurality of silicon substrates 11 may be obtained in a manner of dividing a square regular silicon substrate body at least once according to an unchanged length rule.

Step B: Prepare a front diffusion layer 12, a side division layer, and a back division layer on the silicon substrate 11 to obtain the silicon wafer 1. Specifically, the front diffusion layer 12 is prepared on a front surface of the silicon substrate 11, the side division layer is prepared on a side surface, and the back division layer is prepared on a back surface.

For example, in an example of the disclosure, the side division layer is a side diffusion layer 13 whose type is the same as that of the front diffusion layer 12 and that fully covers the side surface, and the back division layer is a back diffusion layer 14 whose type is the same as that of the front diffusion layer 12 and that fully covers the first area.

Step B is specifically: first, preparing a same type of diffusion layers on all surfaces of the silicon substrate 1; then, applying a protection layer (for example, a paraffin layer or a water film layer) onto parts of the diffusion layer that are used as the front diffusion layer 12, the side diffusion layer 13, and the back diffusion layer 14; then, removing a part, of the diffusion layer, onto which the protection layer is not applied; and finally, removing the protection layer, so as to obtain the front diffusion layer 12, the side diffusion layer 13, and the back diffusion layer 14.

Optionally, the silicon substrate 11 may be made of P-type silicon. In this case, the foregoing diffusion layer may be a phosphorus diffusion layer.

Step C: Fabricate the back electrical layer 6 on the back surface of the silicon substrate 11, and fabricate the second electrode 5 on the back electrical layer 6; fabricate the side electrode 3 on the side division layer; fabricate the first electrode 4 on the back division layer; and fabricate the gate line layer 2 on the front diffusion layer 12.

Herein, it should be noted that, to further increase the power of the photovoltaic cell 100, an anti-reflection layer 101 may be prepared on the front diffusion layer 12, so that the anti-reflection layer 101 fully covers the front diffusion layer 12, and then the gate line layer 2 is prepared on the anti-reflection layer 101 to indirectly prepare the gate line layer 2 on the front diffusion layer 12. Therefore, the anti-reflection layer 101 is disposed to reduce reflection of the photovoltaic cell 100 on sunlight, thereby effectively increasing the power of the photovoltaic cell 100.

Therefore, the method for preparing a photovoltaic cell 100 according to this embodiment of the disclosure has a simple process, is implemented easily, and has low difficulty and low costs.

A photovoltaic cell 100 and a method for preparing same according to a specific embodiment of the disclosure are briefly described below with reference to the accompanying drawings.

As shown in FIG. 1, the photovoltaic cell 100 includes a rectangular sheet-shaped silicon substrate 11, a front surface of the silicon substrate 11 has a front diffusion layer 12, an anti-reflection layer 101 exists on the front diffusion layer 12, a gate line layer 2 exists on the anti-reflection layer 101, a side diffusion layer 13 exists on a side surface on a side of the silicon substrate 11 in a width direction, a side electrode 3 exists on the side diffusion layer 13, and a back surface of the silicon substrate 11 includes a first area and a second area that are spaced, where a first electrode 4 exists on the first area, a back electrical layer 6 exists on the second area, and a second electrode 5 exists on the back electrical layer 6. Shapes and arrangement locations of the foregoing components are shown in FIG. 1 to FIG. 3.

Specifically, when the photovoltaic cell 100 is prepared, a square regular silicon substrate body (for example, a regular silicon substrate whose specification is 156 mm*156 mm) may be first evenly divided and cut, by using laser, into 2 to 8 rectangular sheet-shaped silicon substrates 11 whose lengths are unchanged (for example, each of the lengths is 156 mm), and then a subsequent process of manufacturing the photovoltaic cell 100 is performed. Certainly, the disclosure is not limited thereto, and the rectangular sheet-shaped silicon substrate 11 may be further obtained by using another manner or process. Herein, it should be noted that, when the square regular silicon substrate body is evenly divided into 2 to 8 portions, on one hand, a distance by which charges are migrated from the front surface to the back surface can be shortened, so that charge collection is efficient and easy, thereby increasing the power of the photovoltaic cell 100; and on other hand, the silicon substrate 11 is easily cut and manufactured, and a relatively small amount of solder is consumed when photovoltaic cells 100 are subsequently connected in series or in parallel, thereby improving the entire power after the photovoltaic cells 100 are connected in series or in parallel, and reducing the costs.

The method for preparing a photovoltaic cell 100 is described below by using an example in which the silicon substrate 11 is made of P-type silicon.
a1. Perform cleaning and texturizing: cleaning removes dirt on each surface of the silicon substrate 11, and texturizing reduces the reflectivity of each surface of the silicon substrate 11.
a2. Perform diffusion and junction preparation: double-sided diffusion is performed on the silicon substrate 11 by using a diffusion furnace to prepare a P-N junction, so that each surface of the silicon substrate 11 has a same type of diffusion layer.
a3. Perform mask protection: a diffusion layer (that is, used as a back diffusion layer 14) on a first area and a diffusion layer (that is, used as a side diffusion layer 13) on a side surface adjacent to the first area are protected by using paraffin.
a4. Perform etching: back junctions that are not protected by paraffin and that are on a side surface and a back surface of the silicon substrate 11 are removed.
a5. Remove paraffin protection, and remove phosphosilicate glass, thereby obtaining the back diffusion layer 14 and the side diffusion layer 13 protected by paraffin.
a6. Evaporate an anti-reflection layer 101 on a front diffusion layer 12, where materials of the anti-reflection layer 101 include but are not limited to TiO2, Al2O3, SiNxOy, and SiNxCy.
a7. Screen-print a back electrical layer 6 along a length direction on a second area, screen-print a second electrode 5 along the length direction on the back electrical layer 6, screen-print a first electrode 4 along the length direction on the back diffusion layer 14, and perform drying, where the first electrode 4 exactly coincides with the back diffusion layer 14, and a safe distance exists between the back electrical layer 6 and the first electrode 4, to prevent short-circuit.
a8. Screen-print a gate line layer 2 along a width direction on the front diffusion layer 12 to enable each secondary gate line 21 in the gate line layer 2 to be perpendicular to the second electrode 5, and perform drying.
a9. Screen-print a side electrode 3 along the length direction on the side diffusion layer 13, and perform drying. Herein, it should be noted that, an order of performing steps a7, a8, and a9 may be flexibly changed according to an actual need. In addition, each of "a reverse side" or "a back" mentioned herein means a back surface, and "a front" means a front surface.

A photovoltaic cell array 1000 according to an embodiment of a third aspect of the disclosure is described below.

The photovoltaic cell array 1000 is formed by connecting a plurality of, that is, at least two photovoltaic cells 100 according to the embodiment of the foregoing first aspect in series and/or in parallel. For example, the photovoltaic cell array 1000 may be a first photovoltaic cell array 100A, a second photovoltaic cell array 100B, or a third photovoltaic cell array 100C, where the first photovoltaic cell array 100A is formed by connecting a plurality of photovoltaic cells 100 arranged in a single-column multi-row array in series, the second photovoltaic cell array 100B is formed by connecting a plurality of first photovoltaic cell arrays 100A in parallel, and the third photovoltaic cell array 100C is formed by connecting a plurality of second photovoltaic cell arrays 100B in series.

Therefore, the photovoltaic cell array 1000 according to this embodiment of the disclosure has high power, high energy efficiency, and a simple structure, is manufactured simply and conveniently, and has low costs. Specifically, the power of the photovoltaic cell array 1000 of this embodiment of the disclosure is high, and no diode needs to be added to perform bypass protection, so that the costs are low. In addition, positive and negative connection boxes may be distributed on two sides of the photovoltaic cell array 1000, thereby reducing the use amount of a connection cable between neighboring components, and reducing the costs of a power station.

A solar cell according to an embodiment of a fourth aspect of the disclosure is described below.

The solar cell includes the photovoltaic cell array 1000 of the embodiment of the foregoing third aspect. For example, the solar cell may include sequentially from a front side to a back side: a first panel, a first bonding layer, a photovoltaic cell array 1000, a second bonding layer, and a second panel. The first panel is located on the front side of the photovoltaic cell 100 and may be a glass panel made of a glass material to avoid light shielding, and the second panel is located on the back side of the photovoltaic cell 100 and may be a regular backboard, or the second panel may also be a glass panel made of a glass material. In this case, the solar cell may be a double-glass component. The first bonding layer is disposed between the first panel and the photovoltaic cell 100 and is used to bond the first panel to the photovoltaic cell 100. In this case, the first bonding layer may be made of an EVA (abbreviation of Ethylene Vinyl Acetate, that is, ethylene vinyl acetate copolymer) material or made of a material such as transparent silica gel, so as to ensure a good light transmissive effect. The second bonding layer is disposed between the second panel and the photovoltaic cell 100 and is used to bond the second panel to the photovoltaic cell 100. In this case, the second bonding layer may be made of an EVA (abbreviation of Ethylene Vinyl Acetate, that is, ethylene vinyl acetate copolymer) material or made of a material such as transparent silica gel, so as to ensure a good light transmissive effect. Therefore, the solar cell has higher power, higher energy efficiency, and lower costs, and is manufactured more simply and conveniently.

Solar cells according to two specific embodiments of the disclosure are briefly described below.

### Embodiment 1

A solar cell includes: a first panel, a first insulation layer, a photovoltaic cell array 1000, a second insulation layer, and a second panel disposed sequentially from a front side to a back side, where the photovoltaic cell array 1000 is the foregoing first photovoltaic cell array 100A. That is, a plurality of photovoltaic cells 100 is arranged sequentially in a same placement form (for example, a placement form in which all front surfaces are backward and all side electrodes 3 are downward), and connected in series.

In this case, because a plurality of photovoltaic cells 100 in a single column is placed in a same form, a second electrode 5 of each photovoltaic cell 100 is adjacent to a first electrode 4 of a previous photovoltaic cell 100. In other words, a first electrode 4 of each photovoltaic cell 100 is adjacent to a second electrode 5 of a next photovoltaic cell 100. Therefore, a second electrode 5 and a first electrode 4 of two neighboring photovoltaic cells 100 may be electrically connected by using a conductive band 1001 (for example, a solder strip) along a length direction of a silicon wafer 1, so as to achieve a series-connected objective.

Certainly, the disclosure is not limited thereto, and the second electrode 5 and the first electrode 4 of the two neighboring photovoltaic cells 100 may be further electrically connected by using the conductive band 1001 (for example, the solder strip) along a width direction of the silicon wafer 1. Certainly, the disclosure is still not limited thereto. For example, the second electrode 5 and the first electrode 4 of the two neighboring photovoltaic cells 100 may be further connected in series by using the second panel. Specifically, in this embodiment, a through-hole may exist on the second insulation layer, and the second panel may include a conductor for connecting the neighboring second electrode 5 and first electrode 4 in series and conductively through the through-hole. Therefore, the conductor on the second panel may connect the two neighboring photovoltaic cells 100 in series. Deformed solutions are not described in detail herein.

Therefore, when the foregoing cell is packaged, the following steps may be used. First, a plurality of photovoltaic cells 100 is arranged in a single-column multi-row array, then two neighboring photovoltaic cells 100 are connected in series by using the conductive band 1001 (for example, solder strip) to obtain a photovoltaic cell array 1000, and a busbar 1002 is led out. Then, in an order from the bottom up, the first panel (for example, glass), the first insulation layer (for example, EVA), the photovoltaic cell array 1000, the second insulation layer (for example, EVA), and the second panel (for example, a cell backboard) are laid sequentially, and are placed into a lamination machine and laminated, thereby packaging the solar cell, and obtaining the solar cell.

### Embodiment 2

Embodiment 2 is roughly the same as Embodiment 1, and only a difference is as follows: A photovoltaic cell array 1000 is a third photovoltaic cell array 100C. For example, the third photovoltaic cell array 100C may be formed by first photovoltaic cell arrays 100A in a manner of "three pieces connected in parallel first and then two pieces connected in series". Therefore, when the foregoing back-contact cell is packaged, the following steps may be used. First, a plurality of photovoltaic cells 100 is arranged in a single-column multi-row array, then two neighboring photovoltaic cells 100 are connected in series by using a conductive band 1001 (for example, a solder strip) to obtain a first photovoltaic cell array 100A, then six first photovoltaic cell arrays 100A are connected in parallel three by three by using a busbar 1002 to form two second photovoltaic cell arrays 100B, then the two second photovoltaic cell arrays 100B are connected in series to form the third photovoltaic cell array 100C, thereby obtaining the photovoltaic cell array 1000, and then positive and negative electrodes are respectively led out from two ends of the photovoltaic cell array 1000.

Then, in an order from the bottom up, the first panel (for example, glass), the first insulation layer (for example, EVA), the photovoltaic cell array 1000, the second insulation layer (for example, EVA), and the second panel (for example, a cell backboard or glass) are laid sequentially, and are placed into a lamination machine and laminated, and a connection box and a frame are mounted, thereby packaging and manufacturing the solar cell, and obtaining the solar cell. Herein, it should be noted that, a disposition location of the connection box may be disposed according to an actual requirement, so as to better satisfy the actual requirement. For example, the connection box may be disposed at two edges of the photovoltaic cell array 1000, or may be disposed on back surfaces at two close edges of the photovoltaic cell array 1000.

To sum up, the photovoltaic cell 100 and the photovoltaic cell array 1000 according to the embodiments of the disclosure have the following several advantages.

First, because the first electrode 4 and the second electrode 5 are both located on the back side of the silicon substrate 11, a problem of light shielding of the first electrode 4 for the front surface of the silicon substrate 11 can be effectively resolved, so as to increase the power of the photovoltaic cell 100, reduce the use amount of silver paste, and reduce the production costs. Moreover, because charges collected by the front gate line layer 2 are transferred to the first electrode 4 on the back side in a manner of disposing the side electrode 3 on the side surface of the silicon substrate 11, thereby greatly simplifying the production process of the photovoltaic cell 100, and reducing the manufacturing difficulty and the production costs of the photovoltaic cell 100, photovoltaic cells 100 can be subject to large-scale mass production.

However, in the prior art, for a back-contact cell such as an EWT (emitter wrap-through back-contact cell), a MWT (metal wrap-through back-contact cell), or an IBC (interdigitated back-contact cell), a front surface may completely have no gate line or have no primary gate line to reduce front light shielding. However, the manufacturing process of the back-contact cell such as the EWT, the MWT, or the IBC is quite complex. For example, for the MWT cell and the EWT cell, laser boring needs to be performed on a silicon wafer, and an electrode or an emitter region is manufactured on the back of the cell through a hole, the manufacturing difficulty is large, the costs are high, and a large amount of solder also needs to be consumed when components are manufactured. The requirement of the IBC cell for the manufacturing process is extremely high, and therefore the IBC cell can be subject to only small-scale production.

Second, the second electrode 5 and the first electrode 4 are both located on the back side of the photovoltaic cell 100 and are respectively located on two sides of the silicon substrate 11 in the width direction. Therefore, two neighboring photovoltaic cells 100 may not need to be superimposed, are sequentially arranged, and are directly connected in series, thereby reducing the welding damage rate, or even reducing the solder use amount by approximately 2/3 compared with the existing solder use amount, and then greatly reducing the thermal loss of the conductive band 1001 (for example, solder strip), and effectively improving the power of the photovoltaic cell array 1000. Moreover, the second electrode 5 and the first electrode 4 of the two neighboring photovoltaic cells 100 may be connected on the back side of the photovoltaic cell 100. Therefore, a gap between the two neighboring photovoltaic cells 100 is reduced. Moreover, the busbar 1002 may be directly led out from the photovoltaic cell 100, thereby reducing the total area of the photovoltaic cell array 1000, increasing the effective area of the photovoltaic cell array 1000, and then increasing the power of the photovoltaic cell array 1000.

However, in the prior art, a connection process in which a back electrode of a photovoltaic cell and a front electrode of a neighboring photovoltaic cell are overlapped and connected in series in a tile arrangement manner by using tin paste exists. However, although such a manner may save a large quantity of welding materials and reduce the thermal loss, a method for manufacturing a component in the tile arrangement manner causes breaking or damage of a photovoltaic cell quite easily in a welding process and a subsequent lamination process, and a photovoltaic cell at a lamination location cannot participate in power generation, to cause waste and affect the component power.

Third, the photovoltaic cell array 1000 may be of a structure combining series connection and parallel connection, and then the production costs can be effectively reduced. Therefore, positive and negative connection boxes may be distributed on two sides of the photovoltaic cell array 1000, to reduce the cable use amount and reduce the costs of a power station.

However, in the prior art, all photovoltaic cells in the photovoltaic cell array need to be connected in series sequentially. Therefore, an additional diode needs to be added to perform bypass protection. Not only the reliability is not high and the structure is complex, but also the production costs are high and large-scale mass production is not facilitated.

In the description of the disclosure, it should be understood that orientation or position relationships indicated by the terms such as "on", "below", "front", and "back" are based on orientation or position relationships shown in the accompanying drawings, and are used only for ease and brevity of illustration and description, rather than indicating or implying that the mentioned apparatus or component need to have a particular orientation or need to be constructed and operated in a particular orientation. Therefore, such terms should not be construed as limiting of the disclosure.

In the disclosure, unless specified or limited otherwise, the terms "mounted", "connected", "coupled", and "fixed" should be understood broadly, for example, which may be direct connections, indirectly connected with each other through an intermediate medium, or communication inside two elements or an interaction relationship between two elements. Those of ordinary skill in the art can understand specific meanings of the terms in the disclosure according to specific situations. In the disclosure, unless explicitly specified or limited otherwise, a first characteristic "on" or "under" a second characteristic may be the first characteristic in direct contact with the second characteristic, or the first characteristic in indirect contact with the second characteristic by using an intermediate medium.

In the descriptions of this specification, a description of a reference term such as "an embodiment", "some embodiments", "an example", "a specific example", or "some examples" means that a specific feature, structure, material, or characteristic that is described with reference to the embodiment or the example is included in at least one embodiment or example of the disclosure. In this specification, exemplary descriptions of the foregoing terms do not necessarily refer to a same embodiment or example. In addition, the described specific feature, structure, material, or characteristic may be combined in a proper manner in any one or more embodiments or examples. In addition, with no conflict, a person skilled in the art can integrate and combine different embodiments or examples and features of the different embodiments and examples described in this specification.

Although the embodiments of the disclosure have been shown and described, those skilled in the art can understand that the above embodiments cannot be construed to limit the disclosure, and changes, alternatives, and modifications can be made in the embodiments without departing from the principle and the purpose of the disclosure.

## Claims

1. A photovoltaic cell (100), comprising:
a silicon wafer (1), wherein the silicon wafer (1) comprises a silicon substrate (11), a front diffusion layer (12), a side division layer, and a back division layer, wherein a back surface of the silicon substrate (11) comprises a first area and a second area, the front diffusion layer (12) is disposed on a front surface of the silicon substrate (11), the side division layer is disposed on a side surface of the silicon substrate (11), and the back division layer is disposed on only and fully covers the first area, wherein at least a part of at least one of the side division layer and the back division layer is a diffusion layer whose type is the same as that of the front diffusion layer (12);
a gate line layer (2), wherein the gate line layer (2) is disposed on the front diffusion layer (12);
a side electrode (3), wherein the side electrode (3) is disposed on the side division layer and is electrically connected to the gate line layer (2);
a first electrode (4), wherein the first electrode (4) is disposed on the back division layer and is electrically connected to the side electrode (3); and
a back electrical layer (6) and a second electrode (5), wherein the back electrical layer (6) and the second electrode (5) are both disposed on the second area, wherein the back electrical layer (6) is electrically connected to the second electrode (5) and is not in contact with the first electrode (4).

2. The photovoltaic cell (100) according to claim 1, wherein the back division layer is a back diffusion layer (14) fully covering the first area.

3. The photovoltaic cell (100) according to claim 2, wherein the silicon substrate (11) is of a P-type, and each of the front diffusion layer (12) and the back diffusion layer (14) is a phosphorus diffusion layer.

4. The photovoltaic cell (100) according to claim 1, wherein when being projected along a thickness direction of the silicon wafer (1), each outer edge of the first electrode (4) falls on a profile line of the first area.

5. The photovoltaic cell (100) according to claim 1, wherein each of the first area and the second area is a non-discrete area.

6. The photovoltaic cell (100) according to claim 1, wherein a gap exists between the first area and the second area.

7. The photovoltaic cell (100) according to claim 6, wherein the back electrical layer (6) fully covers the second area, and the second electrode (5) is disposed on the back electrical layer (6).

8. The photovoltaic cell (100) according to claim 1, wherein the side division layer is a side diffusion layer (13) fully covering the side surface of the silicon substrate (11).

9. The photovoltaic cell (100) according to claim 8, wherein the silicon substrate (11) is of a P-type, and each of the front diffusion layer (12) and the side diffusion layer (13) is a phosphorus diffusion layer.

10. The photovoltaic cell (100) according to claim 1, wherein the gate line layer (2) comprises a plurality of secondary gate lines (21) extending perpendicular to a length direction of the side electrode (3).

11. The photovoltaic cell (100) according to claim 1, wherein a span of the silicon wafer (1) in a direction perpendicular to the side electrode (3) is 20 mm to 60 mm.

12. The photovoltaic cell (100) according to claim 11, wherein the silicon wafer (1) is a rectangular sheet, the first electrode (4) and the second electrode (5) are respectively disposed against two long sides of the silicon wafer (1) and extend along a length direction of the silicon wafer (1), and the side electrode is disposed on a side surface, of the silicon wafer (1), adjacent to a long side on a side of the first electrode (4).

13. The photovoltaic cell (100) according to any one of claims 1 to 12, further comprising: an anti-reflection layer (101), wherein the anti-reflection layer (101) is disposed between the gate line layer (2) and the front diffusion layer (12).

14. The photovoltaic cell (100) according to claim 13, wherein the anti-reflection layer (101) is further disposed between the side electrode (3) and the side division layer.

15. A method for preparing a photovoltaic cell (100), wherein the preparation method is used to prepare the photovoltaic cell (100) according to any one of claims 1 to 14, and the preparation method comprises the following steps:
A: obtaining the silicon substrate (11);
B: preparing the front diffusion layer (12), the side division layer, and the back division layer on the silicon substrate (11) to obtain the silicon wafer (1); and
C: preparing the back electrical layer (6), the second electrode (5), the first electrode (4), the side electrode (3), and the gate line layer (2) on the silicon wafer (1).

16. The method for preparing a photovoltaic cell (100) according to claim 15, wherein step A is specifically:
dividing a square regular silicon substrate body at least once according to an unchanged length rule, so as to obtain a plurality of silicon substrates (11).

17. The method for preparing a photovoltaic cell (100) according to claim 15, wherein the back division layer is a back diffusion layer (14) fully covering the first area, the side division layer is a side diffusion layer (13) fully covering the side surface of the silicon substrate (11), and step B is specifically:
B1: preparing a same type of diffusion layers on all surfaces of the silicon substrate (11);
B2: applying a protection layer onto parts of the diffusion layer that are used as the front diffusion layer (12), the side diffusion layer (13), and the back diffusion layer (14);
B3: removing a part, of the diffusion layer, onto which the protection layer is not applied; and
B4: removing the protection layer, so as to obtain the front diffusion layer (12), the side diffusion layer (13), and the back diffusion layer (14).

18. A photovoltaic cell array (1000), formed by connecting a plurality of photovoltaic cells (100) according to any one of claims 1 to 14 in series and/or in parallel.

19. A solar cell, comprising the photovoltaic cell array (1000) according to claim 18.
